# EUROPÄISCHE PATENTSCHRIFT

(11) **EP 3 292 593 B1**
(45) Veröffentlichungstag und Bekanntmachung des Hinweises auf die Patenterteilung: **19.06.2019**
(21) Anmeldenummer: 16709462.2
(22) Anmeldetag: 11.03.2016
(51) Int. Cl.: H01R 12/59, H01R 12/62, H05K 3/36, H01R 43/24

(54) **ELEKTRISCHE VERBINDUNGSANORDNUNG**
ELECTRICAL CONNECTION ARRANGEMENT
DISPOSITIF DE CONNEXION ÉLECTRIQUE

(30) Priorität: 06.05.2015 DE 102015208413
(43) Veröffentlichungstag der Anmeldung: 14.03.2018
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2016/055349
(87) Internationale Veröffentlichungsnummer: WO 2016/177496

(56) Entgegenhaltungen:
- DE-A1-102010 030 063
- DE-A1-102010 039 187
- DE-C1- 19 955 603
- JP-A- 2004 079 226

## Beschreibung

### Gebiet der Erfindung

Die Erfindung betrifft eine elektrische Verbindungsanordnung, welche ein mit einer flexiblen Leiterfolie kontaktiertes Elektronikmodul aufweist. Insbesondere betrifft die Erfindung eine elektrische Verbindungsanordnung mit einem Elektronikmodul für ein Getriebesteuergerät eines Kraftfahrzeugs.

### Stand der Technik

Zur Steuerung von Getrieben, insbesondere Automatikgetrieben, in einem Kraftfahrzeug werden Elektronikmodule verwendet, die in der Regel eine Getriebesteuereinheit mit einer elektronischen Schaltung ("transmission control unit", TCU), mindestens eine Steckverbindung zum Anschluss an einen Fahrzeugkabelbaum, elektrische Schnittstellen zum Ansteuern von Aktuatoren und wenigstens ein Sensorelement aufweisen.

Insbesondere die elektronische Schaltung der Getriebesteuereinheit wird häufig zum Schutz gegen Umgebungseinflüsse, wie etwa ein die Getriebesteuereinheit und/oder das Elektronikmodul umspülendes Getriebefluid, mit einer Schutzmasse, beispielsweise einer Kunststoffmasse aus Duroplast oder Thermoplast, umspritzt und/oder ummoldet.

Die Elektronikmodule und/oder die Getriebesteuereinheiten können beispielsweise mittels einem Leiterplattenelement, einem Stanzgitter und/oder einer Leiterfolie kontaktiert sein.

Die DE 10 2010 039 187 A1 beschreibt eine elektrische Verbindungsanordnung mit einem Elektronikmodul, welches mit einer flexiblen Flachleitung kontaktiert ist, wobei die Flachleitung zwischen einem Kontaktblech und einem Gehäusevorsprung des Elektronikmoduls weitgehend kraftlos einsteckbar ist.

### Offenbarung der Erfindung

### Vorteile der Erfindung

Ausführungsformen der vorliegenden Erfindung können in vorteilhafter Weise ermöglichen, eine robuste, flexible und nahezu zerrüttungsfreie elektrische Verbindungsanordnung, insbesondere für ein Getriebesteuergerät eines Kraftfahrzeugs, bereitzustellen.

Gemäß Anspruch 1 wird eine elektrische Verbindungsanordnung vorgeschlagen, welche ein Elektronikmodul mit einer auf einer Montagefläche eines Leiterplattenelements angeordneten elektronischen Schaltung und eine flexible Leiterfolie mit zwischen einer Basisschicht und einer Deckschicht aufgenommenen Leiterbahnen aufweist. Die Montagefläche des Leiterplattenelements und die elektronische Schaltung sind mit einer Kunststoffmasse als Schutzmasse zum Schutz gegen Umgebungseinflüsse zumindest teilweise, vorzugsweise vollständig, umspritzt und/ oder ummoldet. Das Elektronikmodul weist eine Mehrzahl von nebeneinander angeordneten Kontaktblechen, beispielsweise Kontaktpins, auf, welche jeweils ein von einer Flanke des Elektronikmoduls abragendes Kontaktende aufweisen, wobei die Kontaktenden der Kontaktbleche jeweils mit einer Leiterbahn der Leiterfolie elektrisch leitfähig verbunden sind. Die erfindungsgemäße Verbindungsanordnung zeichnet sich insbesondere dadurch aus, dass an der Flanke des Elektronikmoduls ein Absatz durch die Schutzmasse ausgebildet ist, auf welchem die Kontaktenden der Kontaktbleche und zumindest ein Teilbereich der Leiterfolie abgestützt sind.

Die Kontaktenden und/oder der Teilbereich der Leiterfolie können beispielsweise vollflächig auf dem Absatz abgestützt sein. Der Absatz kann dabei einen durch die Schutzmasse gebildeten Rand des Elektronikmoduls bezeichnen. Der Absatz kann ferner an mehreren Flanken ausgebildet sein. Auch kann der Absatz das Elektronikmodul an einem Außenumfang des Elektronikmoduls umlaufen und/oder z.B. ringförmig umschließen.

Die Verbindungsanordnung und/oder das das Elektronikmodul kann insbesondere in Getriebesteuergeräten eingesetzt werden und dazu ausgeführt sein, von einem Getriebefluid umspült zu werden, wobei die Schutzmasse dazu ausgeführt sein kann, die elektronische Schaltung gegen das diese umspülende Getriebefluid zu schützen. Die elektronische Schaltung kann etwa Teil einer Getriebesteuereinheit für ein Getriebesteuergerät sein.

Durch die erfindungsgemäße Verbindungsanordnung kann eine flache, kompakte und raumsparende Kontaktierung des Elektronikmoduls mit der flexiblen Leiterfolie bereitgestellt sein. Insgesamt kann so eine kompakte Verbindungsanordnung für ein Getriebesteuergerät bereitgestellt sein. Ferner können durch die erfindungsgemäße Kontaktierung die Kontaktenden der Kontaktbleche und/oder Kontaktstellen, an welchen die Kontaktenden mit den Leiterbahnen der Leiterfolie verbunden sein können, umfassend und zuverlässig gegen Kurzschlüsse geschützt sein, welche etwa durch leitfähige Späne und/oder Ablagerungen des die Verbindungsanordnung umspülenden Getriebefluids hervorgerufen sein können.

Ferner können aufgrund der Flexibilität der Leiterfolie, welche z.B. biegeschlaff und/oder mit einer Entlastungswelle in Längsrichtung ausgeführt sein kann, thermomechanische Längenänderungen, wie Wärmeausdehnung und/oder Bi-Metalleffekte der Verbindungsanordnung, sowie Verschiebungen und/oder Schwingungen von Komponenten der Verbindungsanordnung nicht als Scher-, Biege-, Zug- und/oder Druckkräfte auf die elektrischen Kontaktstellen zwischen der Leiterfolie und den Kontaktblechen wirken. Die Kontaktstellen können beispielsweise eine Löt-, Schweiß- und/oder Leitklebeverbindung aufweisen, welche dementsprechend robust, belastungsfrei und nahezu zerrüttungsfrei sein kann.

Auch kann die erfindungsgemäße Verbindungsanordnung und/oder die Kontaktierung der Kontaktbleche mit der Leiterfolie eine automatisierbare Montage der Verbindungsanordnung und ein einfaches Variantenmanagement ermöglichen. Gemäß einer Ausführungsform der Erfindung liegen die Kontaktenden der Kontaktbleche auf dem Absatz auf. Beispielsweise können die Kontaktenden vollflächig auf dem Absatz aufliegen und abgestützt sein. Derart können mechanische auf die Kontaktstellen wirkende Belastungen weiter reduziert sein.

Gemäß einer Ausführungsform der Erfindung sind die Kontaktenden jeweils zumindest teilweise in einer in dem Absatz ausgebildeten Vertiefung aufgenommen. Beispielsweise können die Kontaktenden derart in den Vertiefungen aufgenommen sein, dass eine Kontaktfläche der Kontaktenden bündig mit einer Oberfläche des Absatzes abschließen kann.

Gemäß einer Ausführungsform der Erfindung sind die Kontaktenden der Kontaktbleche jeweils mit einer Leiterbahn der Leiterfolie verlötet, verschweißt und/oder mittels Leitkleber verklebt.

Gemäß einer Ausführungsform der Erfindung ist an den Kontaktenden der Kontaktbleche jeweils ein Schweißbuckel und/oder ein Lotdepot angeordnet. Derart können die Leiterbahnen und die Kontaktenden beispielsweise durch die geschlossene Basis- oder Deckschicht der Leiterfolie z.B. mit einem Laser verschweißt, mittels Bügellöten und/oder durch Aufpressen verbunden werden. Der Schweißbuckel und/oder das Lotdepot kann in etwa die Dicke der Basis- und/oder der Deckschicht der Leiterfolie aufweisen, so dass die Leiterbahnen zuverlässig kontaktiert werden können. Das Lotdepot und/oder der Schweißbuckel kann eine Dicke von rund 10 bis 100 µm aufweisen.

Gemäß einer Ausführungsform der Erfindung ist in dem auf dem Absatz abgestützten Teilbereich der Leiterfolie jeweils wenigstens ein Kontaktbereich jeder Leiterbahn durch Abtragen der Deckschicht oder der Basisschicht der Leiterfolie freigelegt und mit jeweils einem Kontaktende eines Kontaktbleches elektrisch leitfähig verbunden. Beispielsweise können an den Kontaktbereichen Ausnehmungen und/oder Schlitze in der Deck- oder Basisschicht der Leiterfolie eingebracht sein, wobei zwischen den Leiterbahnen die Deck- oder Basisschicht vorhanden, d.h. nicht abgetragen, sein kann.

Gemäß einer Ausführungsform der Erfindung ist in dem auf dem Absatz abgestützten Teilbereich der Leiterfolie die Deckschicht oder die Basisschicht der Leiterfolie zum Kontaktieren der Leiterbahnen mit den Kontaktblechen vollständig entfernt. Mit anderen Worten kann die Leiterfolie in dem Teilbereich nur die Leiterbahnen sowie die Basisschicht oder nur die Leiterbahnen sowie die Deckschicht aufweisen.

Gemäß einer Ausführungsform der Erfindung sind die Kontaktbleche jeweils mit einem dem Kontaktende gegenüberliegenden Ende auf der Montagefläche des Leiterplattenelements angeordnet, wobei die Enden mit einem quer zur Längserstreckungsrichtung der Kontaktbleche verlaufenden und die Kontaktbleche zumindest teilweise überspannenden Querriegel auf der Montagefläche befestigt sind. Die auf der Montagefläche angeordneten Enden der Kontaktbleche können in die Schutzmasse eingebettet sein bzw. von dieser bedeckt sein. Der Querriegel kann aus einem elektrisch isolierenden Material gefertigt sein. Mithilfe des Querriegels können die Kontaktbleche weiter mechanisch stabilisiert sein und eine Robustheit der Verbindungsanordnung kann gesteigert sein.

Gemäß einer Ausführungsform der Erfindung ist zwischen zwei direkt benachbarten Kontaktenden eine Vertiefung in dem Absatz ausgebildet, oder zwischen zwei direkt benachbarten Kontaktenden ist eine Trennwand durch den Absatz ausgebildet. Die Vertiefung und/oder die Trennwand kann als Spanschutz dienen, so dass leitfähige Späne oder Ablagerungen sich nicht auf zwei benachbarten Kontaktenden absetzen und diese dabei kurzschließen können.

Gemäß einer Ausführungsform der Erfindung ist an dem Leiterplattenelement eine Abragung angeordnet, welche zum Positionieren der Leiterfolie zumindest teilweise in eine in die Leiterfolie eingebrachte Positionierausnehmung eingreift. Dies kann insbesondere eine automatisierte Montage und Fügung der Verbindungsanordnung vereinfachen.

Gemäß einer Ausführungsform der Erfindung ist die Leiterfolie in zumindest einem Teilbereich mit dem Elektronikmodul und/oder mit dem Absatz verklebt. Derart kann eine mechanische Stabilität der Verbindungsanordnung weiter gesteigert sein.

Gemäß einer Ausführungsform der Erfindung ist die elektrische Verbindungsanordnungen an Kontaktstellen bzw. Verbindungsbereichen zwischen den Kontaktenden der Kontaktbleche und der Leiterfolie zumindest teilweise von einer Polymermasse zum Schutz gegen Umgebungseinflüsse bedeckt, wobei die Polymermasse ein epoxidharzbasiertes, ein acrylatbasiertes, ein polyurethanbasiertes, ein polyesterbasiertes und/oder ein silikonbasiertes Material enthält. Dadurch können die Kontaktstellen zusätzlich gegen Umgebungseinflüsse geschützt sein.

Ein weiterer Aspekt der Erfindung kann ein Verfahren zum Herstellen einer elektrischen Verbindungsanordnung, so wie obenstehend und untenstehend beschrieben, und/oder ein mit einer Leiterfolie kontaktiertes Elektronikmodul betreffen.

Es wird darauf hingewiesen, dass einige der möglichen Merkmale und Vorteile der Verbindungsanordnung hierin mit Bezug auf unterschiedliche Ausführungsformen beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
Fig. 1A zeigt einen Schnitt durch eine elektrische Verbindungsanordnung gemäß einer Ausführungsform der Erfindung.
Fig. 1B zeigt eine Leiterfolie der Verbindungsanordnung aus Fig. 1A.
Fig. 2A zeigt einen Schnitt durch eine elektrische Verbindungsanordnung gemäß einer Ausführungsform der Erfindung.
Fig. 2B zeigt eine Leiterfolie der Verbindungsanordnung aus Fig. 2A.
Fig. 3A zeigt einen Schnitt durch eine elektrische Verbindungsanordnung gemäß einer Ausführungsform der Erfindung.
Fig. 3B zeigt eine Leiterfolie der Verbindungsanordnung aus Fig. 2A.
Fig. 3C zeigt eine Detailansicht eines Teils der Verbindungsanordnung aus Fig. 3A.
Fig. 4A bis 5B zeigen eine detaillierte Seitenansicht eines Elektronikmoduls für eine elektrische Verbindungsanordnung gemäß Ausführungsformen der Erfindung.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

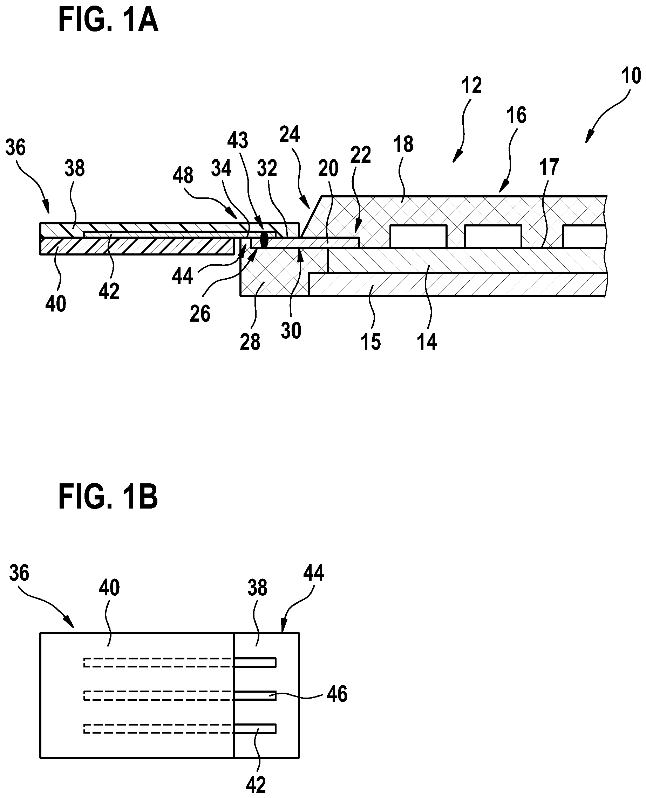

Fig. 1A zeigt einen Schnitt durch eine elektrische Verbindungsanordnung 10 gemäß einer Ausführungsform der Erfindung. Fig. 1B zeigt eine Leiterfolie 36 der Verbindungsanordnung aus Fig. 1A.

Die Verbindungsanordnung 10 weist ein Elektronikmodul 12 mit einem Leiterplattenelement 14 auf, wobei auf einer Montagefläche 17 des Leiterplattenelements 14 eine elektronische Schaltung 16 angeordnet ist. Das Leiterplattenelement 14 kann z.B. ein HDI- ("High-Density Interconnect"), ein PCB ("Printed Circuit Board") Leiterplattenelement und/oder ein anderes Schaltungssubstrat wie Keramik (LTCC, HTCC) sein. Die elektronische Schaltung 16 kann elektronische Bauelemente, wie beispielsweise gehäuste und/oder ungehäuste Siliziumbauelemente, Sensorelemente, Steckverbinder, SMD-Bauelemente ("Surface Mounted Devices") und/oder andere Bauelemente aufweisen. Die elektrische Verbindungsanordnung 10 kann auch eine Mehrzahl von Leiterplattenelementen 14 aufweisen. Das Leiterplattenelement 14 ist mit einer der Montagefläche 17 gegenüberliegen Seite bzw. Fläche auf einem Trägerelement 15, etwa einer Trägerplatte aus Metall und/oder Keramikmaterial, angeordnet und/oder befestigt.

Insbesondere kann die elektronische Schaltung 16 Teil einer Getriebesteuereinheit für ein Getriebesteuergerät eines Kraftfahrzeugs sein. Ferner kann die elektronische Schaltung 16 dazu ausgeführt sein, von einem Getriebefluid umspült zu werden. Dazu sind die elektronische Schaltung 16 und die Montagefläche 17 zumindest teilweise, vorzugsweise vollständig, mit einer Schutzmasse 18 zum Schutz gegen Umgebungseinflüsse und/oder gegen Getriebefluid bedeckt. Die Schutzmasse 18 kann etwa polymerbasiert sein und/oder duroplastisches Material, thermoplastisches Material, silikonbasiertes Material, Polyurethan, acrylbasiertes Material, polyesterbasiertes und/oder acrylatbasiertes Material enthalten.

Das Elektronikmodul 12 weist eine Mehrzahl von Kontaktblechen 20 zum elektrischen Kontaktieren des Elektronikmoduls 12 und/oder der elektronischen Schaltung 16 auf. Die Kontaktbleche sind mit einem Ende 22 auf der Montagefläche 17 befestigt und elektrisch kontaktiert, z.B. verlötet, verschweißt und/oder mittels Leitkleber verklebt. Die Kontaktbleche 20 weisen ferner jeweils ein von einer Flanke 24 des Elektronikmoduls 12 abragendes Kontaktende 26 auf, welches dem Ende 22 jeweils in Längserstreckungsrichtung der Kontaktbleche 20 gegenüberliegt. Es kann auch an mehreren Flanken 24 des Elektronikmoduls 12 wenigstens ein Kontaktblech 20 angeordnet sein. Direkt benachbarte und nebeneinander angeordnete Kontaktbleche 20 können im Wesentlichen parallel zueinander verlaufen und mit deren Kontaktenden 26 von der jeweiligen Flanke 24 des Elektronikmoduls 12 abragen.

Das Elektronikmodul 12 weist ferner an der Flanke 24 einen durch die Schutzmasse 18 gebildeten Absatz 28 auf, auf welchem die Kontaktenden 26 der Kontaktbleche 20 jeweils abgestützt sind. Der Absatz 28 kann dabei an einer Flanke 24 oder an einer Mehrzahl von Flanken 24 des Elektronikmoduls 12 angeordnet sein. Auch kann der Absatz 28 das Elektronikmodul 12 entlang eines Außenumfangs umlaufen und/oder ringförmig umschließen, so dass die Trägerplatte 15, das Leiterplattenelement 14 und/oder die elektronische Schaltung 16 durch den Absatz 28 gegenüber einem seitlichen Eindringen von Getriebefluid in das Elektronikmodul 12 geschützt sein kann.

Bei dem in Fig. 1A gezeigten Ausführungsbeispiel sind die Kontaktenden 26 der Kontaktbleche 20 jeweils in einer Vertiefung 30 des Absatzes 28 angeordnet und/oder aufgenommen. Die Kontaktenden 26 können etwa derart in den Vertiefungen 30 angeordnet sein, dass eine Kontaktfläche 32 der Kontaktenden 26 jeweils im Wesentlichen bündig mit einer Oberfläche 34 des Absatzes 28 abschließt.

Die elektrische Verbindungsanordnung 10 weist ferner eine Leiterfolie 36 auf, welche zwischen einer Basisschicht 38 und einer Deckschicht 40 aufgenommene und/oder angeordnete Leiterbahnen 42 aufweist. Die Deckschicht 40 kann alternativ oder zusätzlich ein Lack sein und/oder einen Lack aufweisen. Die Leiterfolie 36 ist insgesamt flexibel und/oder biegeschlaff ausgestaltet und kann etwa eine flexible Leiterplatte und/oder eine Flexfolie bezeichnen.

Die Kontaktenden 26 der Kontaktbleche 20 sind jeweils an einer Verbindungsstelle bzw. Kontaktstelle 43 mit einer Leiterbahn 42 der Leiterfolie 36 elektrisch leitfähig verbunden. Beispielsweise sind die Kontaktenden 26 mit den Leiterbahnen 42 verlötet, verschweißt und/oder mittels Leitkleber verklebt. Beispielsweise können die Kontaktenden 26 und die Leiterbahnen 42 durch die Deckschicht 40 und/oder durch die Basisschicht 38 hindurch mit einem Laser verschweißt und/oder durch Bügellöten und/oder Anpressen kontaktiert bzw. verbunden werden.

Um eine flache, kompakte und gegen Getriebefluid abgedichtete Kontaktierung zwischen der Leiterfolie 36 und den Kontaktblechen 20 zu gewährleisten ist, wie in Fig. 1B ersichtlich, ein Teilbereich 44 der Deckschicht 40 der Leiterfolie 36 abgetragen bzw. entfernt, so dass ein Kontaktbereich 46 der Leiterbahnen 42 in dem Teilbereich 44 freigelegt ist und mit den Kontaktenden 26 verbunden werden kann. Alternativ kann die Leiterfolie 36 auch umgedreht werden und ein Teilbereich 44 der Basisschicht 38 kann abgetragen werden. Der Teilbereich 44 kann etwa ein Ende der Leiterfolie 36 bezeichnen.

Die Leiterfolie 38 ist derart mit dem Elektronikmodul 12 verbunden, dass der Teilbereich 44 zumindest teilweise auf dem Absatz 26 abgestützt ist und/oder auf dem Absatz 28 aufliegt, so dass eine flache und kompakte Weiterkontaktierung des Elektronikmoduls 12 gegeben sein kann. Vorzugsweise liegt der Teilbereich 44 vollflächig auf dem Absatz 28 und den Kontaktenden 26 auf.

Ein Verbindungsbereich 48 zwischen den Kontaktenden 26 der Kontaktbleche 20 und der Leiterfolie 36 kann ferner zumindest teilweise von einer Polymermasse zum Schutz gegen Umgebungseinflüsse und/oder Getriebefluid bedeckt sein. Die Polymermasse kann ein epoxidharzbasiertes, ein acrylatbasiertes, ein polyesterbasiertes, ein polyurethanbasiertes und/oder ein silikonbasiertes Material enthalten. Der Verbindungsbereich 48 kann dabei insbesondere eine Schnittstelle zwischen der Leiterfolie 36 und dem Elektronikmodul 12 bezeichnen und z.B. den Teilbereich 44 der Leiterfolie 36 sowie die Kontaktenden 26 umfassen. Die Polymermasse kann etwa durch Energiestrahlung (z. B. UV-Licht) und/oder Wärme vernetzt bzw. ausgehärtet werden. Ferner kann der Teilbereich 44 der Leiterfolie 36 zumindest teilweise mit dem Elektronikmodul 12 und/oder mit dem Absatz 28 verklebt sein, so dass kein Getriebefluid bis zu den Kontaktenden 26 und/oder den Kontaktstellen 43 eindringen kann.

Zum Positionieren und/oder automatisierten Fügen der elektrischen Verbindungsanordnung 10 kann das Leiterplattenelement 14 ferner eine Abragung aufweisen, welche zumindest teilweise in eine in die Leiterfolie 36 eingebrachte Positionierausnehmung eingreifen kann. Es kann auch eine Mehrzahl von Abragungen und Positionierausnehmungen vorgesehen sein.

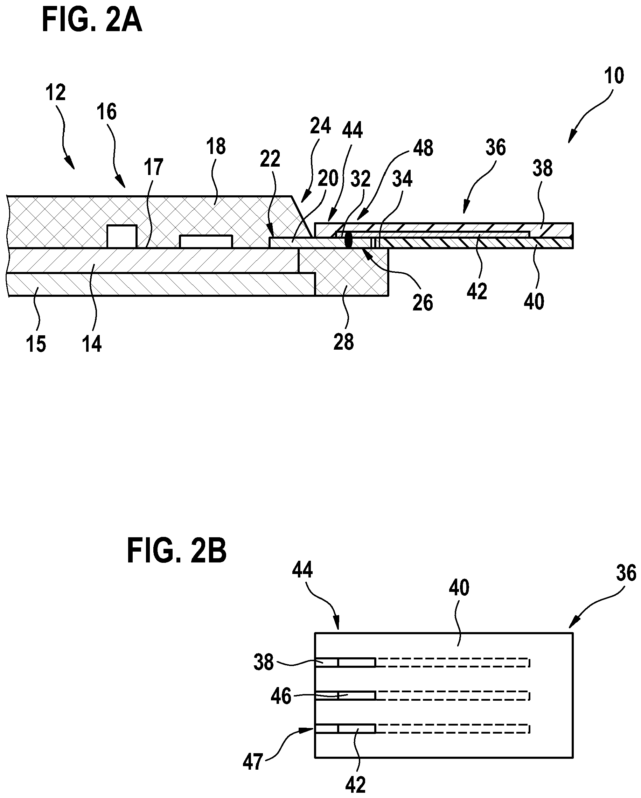

Fig. 2A zeigt einen Schnitt durch eine elektrische Verbindungsanordnung 10 gemäß einer Ausführungsform der Erfindung. Fig. 2B zeigt eine Leiterfolie 36 der Verbindungsanordnung 10 aus Fig. 2A. Sofern nicht anders beschrieben, können die Verbindungsanordnung 10 der Fig. 2A und die Leiterfolie 36 der Fig. 2B dieselben Elemente und Merkmale aufweisen wie die in vorangegangenen Figuren beschriebene Verbindungsanordnung 10 bzw. Leiterfolie 36.

Bei dem in den Fig. 2A und 2B gezeigten Ausführungsbeispiel liegen die Kontaktenden 26 der Kontaktbleche 20 auf dem Absatz 28 bzw. dessen Oberfläche 34 auf, d.h. die Kontaktenden 26 sind nicht in einer Vertiefung 30 des Absatzes 28 aufgenommen, wie bei Fig. 1A gezeigt. Um dennoch eine flache Kontaktierung gewährleisten zu können, ist in dem Teilbereich 44 der Leiterfolie 36 die Deckschicht 40 nicht vollständig entfernt, sondern es sind in dem Teilbereich 44 Schlitze bzw. Ausnehmungen 47 in die Deckschicht 40 eingebracht, so dass die Kontaktbereiche 46 der Leiterbahnen 42 freiliegen und die Kontaktenden 26 jeweils in einer der Ausnehmungen 47 der Deckschickt 40 aufgenommen und/oder angeordnet sind. Zwischen den Kontaktenden 26 kann somit die Deckschicht 40 auf der Oberfläche 34 des Absatzes 28 aufliegen. Alternativ kann die Leiterfolie 36 auch umgedreht werden und die Ausnehmungen 47 können in die Basisschicht 38 eingebracht sein.

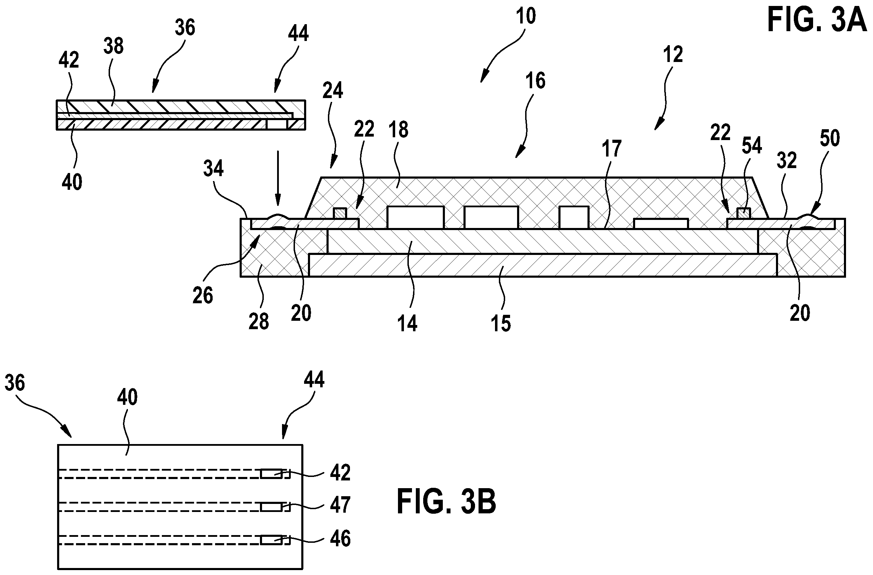

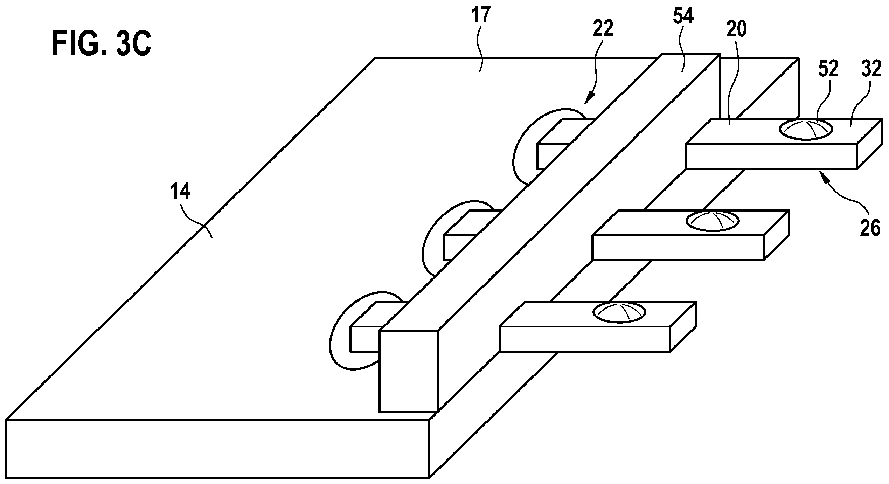

Fig. 3A zeigt einen Schnitt durch eine elektrische Verbindungsanordnung 10 gemäß einer Ausführungsform der Erfindung. Fig. 3B zeigt eine Leiterfolie 36 der Verbindungsanordnung 10 aus Fig. 3A. Fig. 3C zeigt eine Detailansicht der Verbindungsanordnung 10 aus Fig. 3A. Sofern nicht anders beschrieben, können die Verbindungsanordnung 10 der Fig. 3A und die Leiterfolie 36 der Fig. 3B dieselben Elemente und Merkmale aufweisen wie die in vorangegangenen Figuren beschriebene Verbindungsanordnung 10 bzw. Leiterfolie 36.

Bei dem in den Fig. 3A bis 3C gezeigten Ausführungsbeispiel ist an den Kontaktenden 26 der Kontaktbleche 20 jeweils ein Schweißbuckel 50 und/oder ein Lotdepot 52 angeordnet, über welches die Kontaktenden 26 mit den Leiterbahnen 42 der Leiterfolie 36 kontaktiert sind. Die Kontaktenden 26 können entweder auf der Oberfläche 34 des Absatzes 28 aufliegen oder in einer Vertiefung 30 des Absatzes 28 aufgenommen sein. In dem Teilbereich 44 der Leiterfolie 36 ist ferner lediglich ein Kontaktbereich 46 jeder Leiterbahn 42 durch Abtragen der Deckschicht 40 oder der Basisschicht 38 freigelegt, beispielsweise kann eine Ausnehmung 47 in die Deckschicht 40 oder die Basisschicht 38 eingebracht sein, so dass die Kontaktbereiche 46 freiliegen. Die Schweißbuckel 50 und/oder die Lotdepots 52 können jeweils in einer der Ausnehmung 47 aufgenommen sein. Die Schweißbuckel 52 können etwa durch Umformen der Kontaktenden 26 ausgebildet sein. Die Schweißbuckel 50 und/oder die Lotdepots 52 können eine Dicke aufweisen, welche im Wesentlichen einer Dicke der Deckschicht 40 und/oder der Basisschicht 38 entsprechen kann, so dass eine zuverlässige elektrische Verbindung hergestellt werden kann. Beispielsweise können die Schweißbuckel 50 und/oder die Lotdepots 52 eine Dicke von rund 10 bis 100 µm aufweisen.

Weiter sind die Kontaktbleche 20 bzw. die Enden 22 der Kontaktbleche 20 mit einem quer zur Längserstreckungsrichtung der Kontaktbleche 20 verlaufenden und die Kontaktbleche 20 überspannenden elektrisch isolierenden Querriegel 54 auf der Montagefläche 17 des Leiterplattenelements 14 befestigt. Der Querriegel 54 kann etwa aus Kunststoff gefertigt sein und eine mechanische Stabilität der Verbindungsanordnung 10 steigern.

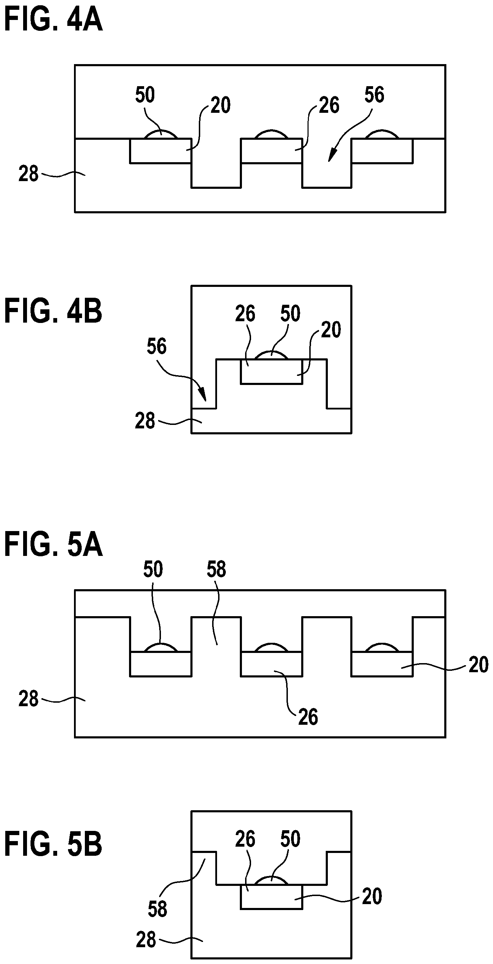

Fig. 4A und 4B zeigen eine detaillierte Seitenansicht eines Elektronikmoduls 12 für eine elektrische Verbindungsanordnung 10 gemäß einer Ausführungsform der Erfindung. Sofern nicht anders beschrieben, kann das Elektronikmodul 12 der Fig. 4A und 4B dieselben Elemente und Merkmale aufweisen wie die in vorangegangenen Figuren beschriebene Elektronikmodule 12.

Zum Schutz gegen Kurzschlüsse, welche etwa durch leitfähige Späne oder Ablagerungen eines das Elektronikmodul 12 umspülenden Getriebefluids hervorgerufen sein können, ist zwischen jeweils zwei direkt benachbarten Kontaktenden 26 eine Vertiefung 56 in dem Absatz 28 ausgebildet, so dass sich Späne und/oder Ablagerungen in den Vertiefungen 56 absetzen können, ohne eine leitfähige Verbindung zwischen zwei Kontaktblechen 20 herzustellen. Die Vertiefungen 56 können so als Spanschutz für die Verbindungsanordnung 10 fungieren.

Die Vertiefungen 56 können dabei jeweils eine Breite aufweisen, welche einem Abstand zweier direkt benachbarter Kontaktenden 20 entspricht, wie in Fig. 4A gezeigt. Alternativ können die Vertiefungen 56 eine Breite aufweisen, welche kleiner als der Abstand zweier direkt benachbarter Kontaktenden 20 ist, so dass die Kontaktenden seitlich an ein Material des Absatzes 28 angrenzen und seitlich in Berührkontakt mit dem Absatz 28 stehen können, wie in Fig. 4B gezeigt.

Fig. 5A und 5B zeigen eine detaillierte Seitenansicht eines Elektronikmoduls 12 für eine elektrische Verbindungsanordnung 10 gemäß einer Ausführungsform der Erfindung. Sofern nicht anders beschrieben, kann das Elektronikmodul 12 der Fig. 5A und 5B dieselben Elemente und Merkmale aufweisen wie die in vorangegangenen Figuren beschriebene Elektronikmodule 12.

Alternativ zu dem bei Fig. 4A und 4B beschriebenen Spanschutz durch Vertiefungen 56 ist bei den Ausführungsbeispielen der Fig. 5A und 5B zwischen je zwei direkt benachbarten Kontaktenden 26 eine Trennwand 58 durch den Absatz 28 ausgebildet, so dass Späne und Ablagerungen nicht zwei benachbarte Kontaktenden 26 kurzschließen können.

Ähnlich den Vertiefungen 56 der Fig. 4A und 4B können die Trennwände 58 jeweils eine Breite aufweisen, welche einem Abstand zweier direkt benachbarter Kontaktenden 20 entspricht, wie in Fig. 5A gezeigt, oder sie können eine Breite aufweisen, welche kleiner als der Abstand zweier direkt benachbarter Kontaktenden 20 ist, wie in Fig. 5B gezeigt.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Elektrische Verbindungsanordnung (10), aufweisend:
ein Elektronikmodul (12) mit einer auf einer Montagefläche (17) eines Leiterplattenelements (14) angeordneten elektronischen Schaltung (16); und
eine flexible Leiterfolie (36) mit zwischen einer Basisschicht (38) und einer Deckschicht (40) aufgenommenen Leiterbahnen (42),
wobei die Montagefläche des Leiterplattenelements und die elektronische Schaltung zumindest teilweise mit einer Kunststoffmasse als Schutzmasse (18) zum Schutz gegen Umgebungseinflüsse umspritzt und/oder ummoldet sind,
wobei das Elektronikmodul eine Mehrzahl von nebeneinander angeordneten Kontaktblechen (20) aufweist, welche jeweils ein von einer Flanke (24) des Elektronikmoduls abragendes Kontaktende (26) aufweisen, und
wobei die Kontaktenden der Kontaktbleche jeweils mit einer Leiterbahn der Leiterfolie elektrisch leitfähig verbunden sind,
**dadurch gekennzeichnet, dass**
an der Flanke (24) des Elektronikmoduls (12) ein Absatz (28) durch die Schutzmasse (18) ausgebildet ist, auf welchem die Kontaktenden (26) der Kontaktbleche (20) und zumindest ein Teilbereich (44) der Leiterfolie abgestützt sind.

2. Elektrische Verbindungsanordnung (10) nach Anspruch 1, wobei die Kontaktenden (26) der Kontaktbleche auf dem Absatz (28) aufliegen; und/oder wobei die Kontaktenden jeweils zumindest teilweise in einer in dem Absatz ausgebildeten Vertiefung (30) aufgenommen sind.

3. Elektrische Verbindungsanordnung (10) nach einem der voranstehenden Ansprüche, wobei die Kontaktenden der Kontaktbleche jeweils mit einer Leiterbahn der Leiterfolie verlötet, verschweißt und/oder mittels Leitkleber verklebt sind.

4. Elektrische Verbindungsanordnung (10) nach einem der voranstehenden Ansprüche, wobei an den Kontaktenden der Kontaktbleche jeweils ein Schweißbuckel (50) und/oder ein Lotdepot (52) angeordnet ist.

5. Elektrische Verbindungsanordnung (10) nach einem der voranstehenden Ansprüche, wobei in dem auf dem Absatz (28) abgestützten Teilbereich (44) der Leiterfolie jeweils ein Kontaktbereich (46) jeder Leiterbahn durch Abtragen der Deckschicht (40) oder der Basisschicht (38) der Leiterfolie freigelegt und mit jeweils einem Kontaktende (26) eines Kontaktbleches elektrisch leitfähig verbunden ist.

6. Elektrische Verbindungsanordnung (10) nach einem der voranstehenden Ansprüche, wobei in dem auf dem Absatz (28) abgestützten Teilbereich (44) der Leiterfolie die Deckschicht (40) oder die Basisschicht (38) der Leiterfolie zum Kontaktieren der Leiterbahnen mit den Kontaktblechen vollständig entfernt ist.

7. Elektrische Verbindungsanordnung (10) nach einem der voranstehenden Ansprüche, wobei die Kontaktbleche jeweils mit einem dem Kontaktende gegenüberliegenden Ende (22) auf der Montagefläche (17) des Leiterplattenelements (14) angeordnet sind, und
wobei die Enden (22) mit einem quer zur Längserstreckungsrichtung der Kontaktbleche verlaufenden und die Kontaktbleche überspannenden Querriegel (54) auf der Montagefläche befestigt sind.

8. Elektrische Verbindungsanordnung (10) nach einem der voranstehenden Ansprüche, wobei zwischen zwei direkt benachbarten Kontaktenden (26) eine Vertiefung (56) in dem Absatz (28) ausgebildet ist; oder
wobei zwischen zwei direkt benachbarten Kontaktenden eine Trennwand (58) durch den Absatz ausgebildet ist.

9. Elektrische Verbindungsanordnung (10) nach einem der voranstehenden Ansprüche, wobei an dem Leiterplattenelement eine Abragung angeordnet ist, welche zum Positionieren der Leiterfolie zumindest teilweise in eine in die Leiterfolie eingebrachte Positionierausnehmung eingreift; und/oder
wobei der Teilbereich der Leiterfolie zumindest teilweise mit dem Elektronikmodul und/oder mit dem Absatz verklebt ist.

10. Elektrische Verbindungsanordnung (10) nach einem der voranstehenden Ansprüche, wobei die elektrische Verbindungsanordnungen an einem Verbindungsbereich (48) zwischen den Kontaktenden (26) der Kontaktbleche und der Leiterfolie zumindest teilweise von einer Polymermasse zum Schutz gegen Umgebungseinflüsse bedeckt ist,
wobei die Polymermasse ein epoxidharzbasiertes, ein acrylatbasiertes, ein polyurethanbasiertes, ein polyesterbasiertes, und/oder ein silikonbasiertes Material enthält.

## Claims

1. Electrical connecting arrangement (10) having:
an electronic module (12) with an electronic circuit (16) arranged on a mounting surface (17) of a circuit board element (14); and
a flexible printed circuit foil (36) with conductor tracks (42) received between a base layer (38) and a top layer (40),
wherein the mounting surface of the circuit board element and the electronic circuit are insert-molded and/or overmolded at least partially with a plastic compound as protective compound (18) for protection against environmental influences,
wherein the electronic module has a plurality of contact plates (20), arranged alongside one another,
which each have a contact end (26) projecting from a flank (24) of the electronic module, and
wherein the contact ends of the contact plates are each connected in an electrically conductive manner to a conductor track of the printed circuit foil,
**characterized in that**
a shoulder (28) is formed by the protective compound (18) at the flank (24) of the electronic module (12), the contact ends (26) of the contact plates (20) and at least a subregion (44) of the printed circuit foil being supported on said shoulder (28).

2. Electrical connecting arrangement (10) according to Claim 1, wherein the contact ends (26) of the contact plates rest on the shoulder (28); and/or
wherein the contact ends are each received at least partially in a depression (30) formed in the shoulder.

3. Electrical connecting arrangement (10) according to either of the preceding claims, wherein the contact ends of the contact plates are each soldered, welded and/or adhesively bonded by means of conductive adhesive to a conductor track of the printed circuit foil.

4. Electrical connecting arrangement (10) according to one of the preceding claims, wherein a weld projection (50) and/or a solder deposit (52) is arranged at each of the contact ends of the contact plates.

5. Electrical connecting arrangement (10) according to one of the preceding claims, wherein, in the subregion (44), supported on the shoulder (28), of the printed circuit foil, in each case one contact region (46) of each conductor track is exposed by removal of the top layer (40) or the base layer (38) of the printed circuit foil and is connected in an electrically conductive manner to in each case one contact end (26) of a contact plate.

6. Electrical connecting arrangement (10) according to one of the preceding claims, wherein, in the subregion (44), supported on the shoulder (28), of the printed circuit foil, the top layer (40) or the base layer (38) of the printed circuit foil has been completely removed in order to bring the conductor tracks into contact with the contact plates.

7. Electrical connecting arrangement (10) according to one of the preceding claims, wherein the contact plates are each arranged with an end (22) opposite the contact end on the mounting surface (17) of the circuit board element (14), and
wherein the ends (22) are fastened to the mounting surface with a crossbar (54) that extends transversely to the direction of longitudinal extent of the contact plates and spans the contact plates.

8. Electrical connecting arrangement (10) according to one of the preceding claims, wherein a depression (56) is formed in the shoulder (28) between two directly adjacent contact ends (26); or
wherein a partition (58) is formed by the shoulder between two directly adjacent contact ends.

9. Electrical connecting arrangement (10) according to one of the preceding claims, wherein a projection is arranged on the circuit board element, said projection engaging at least partially in a positioning recess introduced into the printed circuit foil in order to position the printed circuit foil; and/or
wherein the subregion of the printed circuit foil is adhesively bonded at least partially to the electronic module and/or to the shoulder.

10. Electrical connecting arrangement (10) according to one of the preceding claims, wherein, in a connecting region (48) between the contact ends (26) of the contact plates and the printed circuit foil, the electrical connecting arrangement is covered at least partially by a polymer compound for protection against environmental influences,
wherein the polymer compound contains an epoxy-resin-based, an acrylate-based, a polyurethane-based, a polyester-based, and/or a silicone-based material.

## Revendications

1. Arrangement de liaison électrique (10), qui possède :
un module électronique (12)
comprenant un circuit électronique (16) disposé sur une surface de montage (17) d'un élément de circuit imprimé (14) ; et
un film conducteur souple (36) comprenant des pistes conductrices (42) accueillies entre une couche de base (38) et une couche de recouvrement (40),
la surface de montage de l'élément de circuit imprimé et le circuit électronique étant au moins partiellement surmoulés et/ou enrobés par une masse en matière plastique en tant que masse de protection (18) destinée à la protection contre les influences environnementales, le module électronique possédant une pluralité de tôles de contact (20) disposées les unes à côté des autres, lesquelles possèdent respectivement une extrémité de contact (26) qui fait saillie depuis un flanc (24) du module électronique, et
les extrémités de contact des tôles de contact étant respectivement reliées de manière électriquement conductrice à une piste conductrice du film conducteur,
**caractérisé en ce que**
un talon (28) est formé par la masse de protection (18) au niveau du flanc (24) du module électronique (12), sur lequel s'appuient les extrémités de contact (26) des tôles de contact (20) et au moins une zone partielle (44) du film conducteur.

2. Arrangement de liaison électrique (10) selon la revendication 1, les extrémités de contact (26) des tôles de contact reposant sur le talon (28) ; et/ou les extrémités de contact étant respectivement au moins partiellement accueillies dans une cavité (30) formée dans le talon.

3. Arrangement de liaison électrique (10) selon l'une des revendications précédentes, les extrémités de contact des tôles de contact étant respectivement brasées, soudées et/ou collées au moyen d'un adhésif conducteur à une piste conductrice du film conducteur.

4. Arrangement de liaison électrique (10) selon l'une des revendications précédentes, un plot à souder (50) et/ou un dépôt de brasure (52) étant respectivement disposé au niveau des extrémités de contact des tôles de contact.

5. Arrangement de liaison électrique (10) selon l'une des revendications précédentes, une zone de contact (46) de chaque piste conductrice étant libérée par enlèvement de la couche de recouvrement (40) ou de la couche de base (38) dans la zone partielle (44) du film conducteur qui prend appui sur le talon (28), puis reliée électriquement respectivement à une extrémité de contact (26) d'une tôle de contact.

6. Arrangement de liaison électrique (10) selon l'une des revendications précédentes, la couche de recouvrement (40) ou la couche de base (38) étant entièrement retirée dans la zone partielle (44) du film conducteur qui prend appui sur le talon (28) en vue d'établir le contact des pistes conductrices avec les tôles de contact.

7. Arrangement de liaison électrique (10) selon l'une des revendications précédentes, les tôles de contact étant respectivement disposées avec une extrémité (22) à l'opposé de l'extrémité de contact sur la surface de montage (17) de l'élément de circuit imprimé (14), et les extrémités (22) étant fixées sur la surface de contact avec un verrou transversal (54) qui s'étend transversalement au sens de projection longitudinal des tôles de contact et qui enjambe les tôles de contact.

8. Arrangement de liaison électrique (10) selon l'une des revendications précédentes, une cavité (56) étant formée dans le talon (28) entre deux extrémités de contact (26) directement voisines ; ou
une paroi de séparation (58) étant formée par le talon entre deux extrémités de contact directement voisines.

9. Arrangement de liaison électrique (10) selon l'une des revendications précédentes, une saillie étant disposée au niveau de l'élément de circuit imprimé, laquelle vient au moins partiellement en prise dans un logement de positionnement pratiqué dans le film conducteur en vue de positionner le film conducteur ; et/ou
la zone partielle du film conducteur étant au moins partiellement collée avec le module électronique et/ou avec le talon.

10. Arrangement de liaison électrique (10) selon l'une des revendications précédentes, les arrangements de liaison électrique étant au moins partiellement recouverts, au niveau d'une zone de liaison (48) entre les extrémités de contact (26) des tôles de contact et le film conducteur, d'une masse de polymère servant à la protection contre les influences environnementales,
la masse de polymère contenant un matériau à base de résine d'époxy, à base d'acrylate, à base de polyuréthane, à base de polyester et/ou à base de silicone.
